# EUROPEAN PATENT APPLICATION

(11) **EP 4 626 158 A1**
(43) Date of publication of application: **01.10.2025**
(21) Application number: 23899680.5
(22) Date of filing: 07.11.2023
(51) Int. Cl.: H05K 7/20

(54) **COLD PLATE ASSEMBLY, ELECTRONIC DEVICE, AND LIQUID COOLING SYSTEM**

(30) Priority: 06.12.2022 CN 202211559617; 14.03.2023 CN 202310270108
(71) Applicant: Huawei Technologies Co., Ltd., Shenzhen, Guangdong 518129 (CN)
(72) Inventor: WEN, Chuanwei, Shenzhen, Guangdong 518129 (CN); LI, Xiaochu, Shenzhen, Guangdong 518129 (CN); HUANG, Manjin, Shenzhen, Guangdong 518129 (CN)
(74) Representative: Maiwald GmbH
(86) International application number: PCT/CN2023/130151
(87) International publication number: WO 2024/120099

(57) **Abstract**

A cold plate assembly (6), an electronic device, and a liquid cooling system are provided. The cold plate assembly (6) includes a cold plate body (12) and a flexible printed circuit (13). The cold plate body (12) is provided with a cooling liquid flow channel (14) for flowing of cooling liquid. The cold plate body (12) is connected to an electronic component (16) in a thermally conductive manner, and the cooling liquid is used to conduct heat of the electronic component (16) through the cold plate body (12), to dissipate the heat for the electronic component (16). The flexible printed circuit (13) is integrated on the cold plate body (12), and the flexible printed circuit (13) is provided with a high-speed signal cable and a power interconnection cable, where the high-speed signal cable and the power interconnection cable are separately used to electrically connect to the electronic component (16). The high-speed signal cable is used to communicate a high-speed signal with the electronic component (16), and the power interconnection cable is used to supply power to the electronic component (16). The flexible printed circuit (13) is made of a flexible material and has insulation. The cold plate assembly (6) has three functions: heat dissipation, signal transmission, and power supply, and cable connections are reduced in the electronic device. This helps reduce cables in the electronic device and reduce a size of the electronic device.

## Description

### CROSS-REFERENCE TO RELATED APPLICATIONS

This application claims priority to Chinese Patent Application No. 202211559617.8, filed with the China National Intellectual Property Administration on December 6, 2022 and entitled "CIRCUIT BOARD ASSEMBLY AND ELECTRONIC DEVICE", which is incorporated herein by reference in its entirety. This application claims priority to Chinese Patent Application No. 202310270108.1, filed with the China National Intellectual Property Administration on March 14, 2023 and entitled "COLD PLATE ASSEMBLY, ELECTRONIC DEVICE, AND LIQUID COOLING SYSTEM", which is incorporated herein by reference in its entirety.

### TECHNICAL FIELD

This application relates to the field of electronic device technologies, and specifically, to a cold plate assembly, an electronic device, and a liquid cooling system.

### BACKGROUND

With development of technologies, a requirement for evolution of electronic components gradually increases, and an interface rate of the electronic components also gradually increases, for example, from 25 Gbps to 112 Gbps. Interconnection between modules or boards transitions from printed circuit board (PCB) interconnection to a high-speed cable interconnection architecture. In an existing interconnection solution, cables are used for implementing a connection and power supply between the modules or the boards. However, the cables occupy large space, and maintenance is complex.

### SUMMARY

This application provides a cold plate assembly, an electronic device, and a liquid cooling system, so that the cold plate assembly has three functions: heat dissipation, signal transmission, and power supply, and cable connections are reduced. This helps reduce cables in the electronic device and reduce a size of the electronic device.

According to a first aspect, this application provides a cold plate assembly, where the cold plate assembly includes a cold plate body and a flexible printed circuit. The cold plate body is provided with a cooling liquid flow channel, where the cooling liquid flow channel is used for flowing of cooling liquid. The cold plate body is connected to an electronic component in a thermally conductive manner, and the cooling liquid is used to conduct heat of the electronic component through the cold plate body, to dissipate the heat for the electronic component. The flexible printed circuit is integrated on the cold plate body, and the flexible printed circuit is provided with a high-speed signal cable and a power interconnection cable, where the high-speed signal cable and the power interconnection cable are separately used to electrically connect to the electronic component. Specifically, the high-speed signal cable is used to communicate a high-speed signal with the electronic component, and the power interconnection cable is used to supply power to the electronic component. The flexible printed circuit is made of a flexible material and has insulation. In this technical solution, the cold plate assembly has three functions: heat dissipation, signal transmission, and power supply. To be specific, the cold plate assembly can dissipate the heat for the electronic component in a circuit board module, and can implement the signal transmission and a power supply connection for different circuit board modules, so that cable connections are reduced. This helps reduce cables in the electronic device and reduce a size of the electronic device.

When the flexible printed circuit is specifically disposed, the flexible printed circuit may be integrated on a surface on one side of the cold plate body, or may be integrated on surfaces on two sides of the cold plate body. First, the flexible printed circuit is integrated on a surface of the cold plate body, so that the high-speed signal cable and the power interconnection cable are electrically connected to the electronic component separately. Second, the flexible printed circuit may be integrated on the surface on the one side of the cold plate body or may be integrated on the surfaces on the two sides of the cold plate body according to a requirement. Specifically, this may be determined based on a quantity of circuit board modules connected to the cold plate assembly. For example, when the quantity of circuit board modules connected to the cold plate assembly is large, the flexible printed circuit may be integrated on the surfaces on the two sides of the cold plate body, and the foregoing circuit board modules may be disposed on two sides of a cold plate. This helps further improve integration of the electronic device.

Specifically, when the flexible printed circuit is integrated on the cold plate body, a process and a specific method that are used are not limited. For example, the surface of the cold plate body may be provided with a mounting groove, and the flexible printed circuit is embedded in the mounting groove. Alternatively, the flexible printed circuit may be directly attached to the surface of the cold plate body. In addition, the flexible printed circuit may be fixedly connected to the cold plate body by using a process such as bonding or welding. This is not limited in this application.

In addition, a size of the flexible printed circuit is not specifically limited in this application. In a possible technical solution, an area of the flexible printed circuit is less than an area of a surface that is of the cold plate body and that faces the flexible printed circuit. Specifically, the flexible printed circuit avoids a region in which the cold plate body is connected to the electronic component in a thermally conductive manner. In this solution, a manner of disposing the flexible printed circuit enables the electronic component to be directly connected to the cold plate body in a thermally conductive manner, and no flexible printed circuit needs to be disposed between the electronic component and the cold plate body, so that a link between the electronic component and the cold plate body is shortened, thermal resistance is reduced, and heat exchange efficiency of the electronic component is improved.

A quantity of flexible printed circuits integrated on the cold plate body and a shape of the flexible printed circuit integrated on the cold plate body are not limited, and may be specifically designed according to a requirement. For example, one or more flexible printed circuits may be integrated on the cold plate body. When the cold plate body includes one flexible printed circuit, the flexible printed circuit may be in a regular shape or an irregular shape. To avoid the region in which the cold plate body is connected to the electronic component in a thermally conductive manner, the flexible printed circuit may have a hollow-out structure, so that the cold plate body may be connected, in a thermally conductive manner, to the electronic component by using the hollow-out structure. In a technical solution, an edge shape of the flexible printed circuit may be the same as an edge shape of the cold plate body. When the cold plate body includes a plurality of flexible printed circuits, the plurality of flexible printed circuits may be disposed away from the region in which the cold plate body is connected to the electronic component in a thermally conductive manner. Regardless of which solution is used, a design idea is mainly to avoid the region in which the cold plate body is connected to the electronic component in a thermally conductive manner, and shorten a connection path of the different circuit board modules, to improve a heat dissipation capability of the circuit board module and improve efficiency of the signal transmission between the different circuit board modules.

To improve a heat dissipation capability of the flexible printed circuit, an insulated thermal interface material layer may be disposed between the flexible printed circuit and the cold plate body, so that the cold plate body may be used for dissipating heat for the high-speed signal cable and the power interconnection cable in the flexible printed circuit, to prolong a service life of the high-speed signal cable and the power interconnection cable in the flexible printed circuit.

When a connection between the flexible printed circuit and the circuit board module is specifically implemented, the flexible printed circuit may be provided with a first connector, and the first connector is electrically connected to the high-speed signal cable and the power interconnection cable. The electronic component is connected to the first connector. Specifically, the electronic component may be connected to a second connector, and the first connector is connected to the second connector, so that the electronic component is connected to the first connector. In this solution, the electronic component in the circuit board module is detachably connected to a cold plate module, so that a connection relationship can be flexibly adjusted, and the circuit board module can be repaired, replaced, and the like.

A specific form of the first connector is not limited. For example, the first connector is an elastic connector. The elastic connector has elasticity to some extent, so that a floating connection is implemented between the circuit board module and the cold plate assembly, to absorb a tolerance between the circuit board module and the cold plate assembly, reduce a coplanar constraint between the circuit board module and the cold plate assembly, and facilitate mounting.

To facilitate a connection between the circuit board module and the cold plate assembly, the cold plate assembly may further include a first positioning assembly. The first positioning assembly includes a first guide pin and a second guide pin, and a preset distance exists between surfaces that are of the first guide pin and the second guide pin and that face each other. The first positioning assembly is configured to position a location the electronic component in the cold plate assembly. During actual mounting, a distance between the electronic component and the first positioning assembly is a preset distance, and the circuit board module has a second positioning assembly that adapts to the first positioning assembly. The first positioning assembly and the second positioning assembly are first mounted in contact to implement preliminary positioning, to improve positioning precision between the circuit board module and the cold plate assembly, and facilitate simplification of a mounting process.

The flexible printed circuit implements the signal transmission and the power supply inside the cold plate assembly, but signal transmission and power supply may also need to be performed between different cold plate assemblies. Therefore, the flexible printed circuit in this application is further provided with a first board to board connector, the first board to board connector is electrically connected to the high-speed signal cable and the power interconnection cable, and the first board to board connector is configured to electrically connect to a cable. In this solution, the cold plate assembly may further be connected to another circuit board assembly through the cable and the first board to board connector, to perform signal transmission and power supply.

According to a second aspect, this application further provides an electronic device. The electronic device includes the cold plate assembly in the first aspect and a plurality of circuit board modules. The circuit board module includes an electronic component, the circuit board module is mounted on the cold plate assembly, the circuit board module is electrically connected to the high-speed signal cable and is electrically connected to the power interconnection cable, and at least two circuit board modules are electrically connected through the high-speed signal cable and the power interconnection cable. Specifically, the electronic component in the circuit board module is electrically connected to the high-speed signal cable and is electrically connected to the power interconnection cable, and electronic components of the at least two circuit board modules are electrically connected through the high-speed signal cable and the power interconnection cable. In this solution, the cold plate assembly has three functions: heat dissipation, signal transmission, and power supply, can dissipate the heat for the electronic component in the circuit board module, and can implement the signal transmission and a power supply connection for different circuit board modules, so that cable connections are reduced. This helps reduce cables in the electronic device and reduce a size of the electronic device.

In a possible technical solution, the flexible printed circuit is integrated on surfaces on two sides of the cold plate body, and the circuit board modules are separately disposed on two sides of the cold plate assembly. One cold plate assembly may be connected to a large quantity of circuit board modules, and perform heat dissipation, signal transmission, and power supply on the large quantity of circuit board modules. This helps reduce a quantity of cold plate assemblies in the electronic device and improve integration of the electronic device.

In a specific technical solution, the circuit board module includes a circuit board, the electronic component, and a second connector. The electronic component and the second connector are disposed on the circuit board, and the electronic component and the second connector are electrically connected through the circuit board. The flexible printed circuit is further provided with a first connector, and the first connector is electrically connected to the high-speed signal cable and the power interconnection cable. The first connector is connected to the second connector, so that the electronic component can be electrically connected to the high-speed signal cable and the power interconnection cable in the flexible printed circuit. In this solution, the electronic component in the circuit board module is detachably connected to a cold plate module, so that a connection relationship can be flexibly adjusted, and the circuit board module can be repaired, replaced, and the like.

Specific forms of the first connector and the second connector are not limited. In a technical solution, the first connector and the second connector are elastic connectors. The elastic connector in this solution enables a floating connection between the circuit board module and the cold plate assembly, to absorb a tolerance between the circuit board module and the cold plate assembly, reduce a coplanar constraint between the circuit board module and the cold plate assembly, and facilitate mounting.

To facilitate positioning when the circuit board module is connected to the cold plate assembly, the cold plate assembly further includes a first positioning assembly, where the first positioning assembly includes a first guide pin and a second guide pin, and a preset distance exists between surfaces that are of the first guide pin and the second guide pin and that face each other. The circuit board module further includes a second positioning assembly, where the second positioning assembly includes a first holder and a second holder, and the preset distance exists between surfaces that are of the first holder and the second holder and that face away from each other. The first holder and the second holder are mounted between the first guide pin and the second guide pin, and are used to position the circuit board module and the cold plate assembly. Therefore, when the circuit board module is mounted on the cold plate assembly, the first holder and the second holder first extend between the first guide pin and the second guide pin, and then the first connector is connected to the second connector. Therefore, the first positioning assembly and the second positioning assembly implement preliminary positioning, to improve positioning precision between the circuit board module and the cold plate assembly, and facilitate simplification of a mounting process.

To improve a heat dissipation effect of the cold plate body on the electronic component, the cold plate body may have a boss, and the boss is connected to the electronic component in a thermally conductive manner. In this solution, the circuit board module implements the signal transmission and the power supply through the high-speed signal cable and the power interconnection cable that are disposed in the flexible printed circuit. In addition, for signal transmission and power supply between circuit board modules that are far away from each other or circuit board modules that are disposed with different cold plate assemblies, a second board to board connector may be disposed in the circuit board module, and the second board to board connector may be connected to a cable, so that signal transmission and the power supply between the circuit board modules that are far away from each other or the circuit board modules that are disposed with the different cold plate assemblies may be implemented through the cable, and application scenarios of the electronic device can be enriched.

A type of the circuit board module included in the electronic device in this application is not limited. For example, at least two circuit board modules may include a switching module and a computing module, and the computing module is arranged on a periphery of the switching module. A large quantity of computing modules are close to the switching module, so that the large quantity of computing modules are connected to the switching module by using the cold plate assembly, to implement signal switching, and efficiency of signal transmission between the switching module and the computing module can be improved.

According to a third aspect, this application further provides a liquid cooling system. The liquid cooling system includes a cooling device, a liquid pump, and the cold plate assembly in the first aspect. The cold plate assembly is disposed in the electronic device in the second aspect. The cooling device and the liquid pump are connected to a cooling liquid flow channel of a cold plate body. Driven by the liquid pump, cooling liquid circulates between the cooling device and the cooling liquid flow channel, to dissipate heat for an electronic component in the electronic device, and prolong a service life and improve computing power of the electronic component.

### BRIEF DESCRIPTION OF DRAWINGS

FIG. 1 is a diagram of a connection between circuit board modules in a conventional technology;
FIG. 2 is a diagram of a lateral structure of an electronic device having a liquid cooling system according to this application;
FIG. 3 is a diagram of a top-view structure of an electronic device according to this application;
FIG. 4 is a diagram of a lateral structure of a circuit board assembly according to this application;
FIG. 5 is a diagram of a structure of a cold plate assembly according to this application;
FIG. 6 is a diagram of a partial sectional view of another circuit board assembly according to this application;
FIG. 7 is a diagram of a structure of an electronic device according to an embodiment of this application; and
FIG. 8 is a diagram of a lateral structure of a circuit board assembly according to this application.

### Reference numerals:

1: Cable; 2: Circuit board module
3: Housing; 4: Circuit board assembly
5: Circuit board for management; 6: Cold plate assembly
7: Liquid pump; 8: Cooling device
9: Liquid pipeline; 10: Liquid inlet channel
11: Liquid outlet channel; 12: Cold plate body
13: Flexible printed circuit; 14: Cooling liquid flow channel
15: Circuit board; 16: Electronic component
17: Insulated thermal interface material layer; 18: Boss
19: First connector; 20: Second connector
21: First guide pin; 22: Second guide pin
23: First holder; 24: Second holder
25: First board to board connector; 26: Second board to board connector

### DESCRIPTION OF EMBODIMENTS

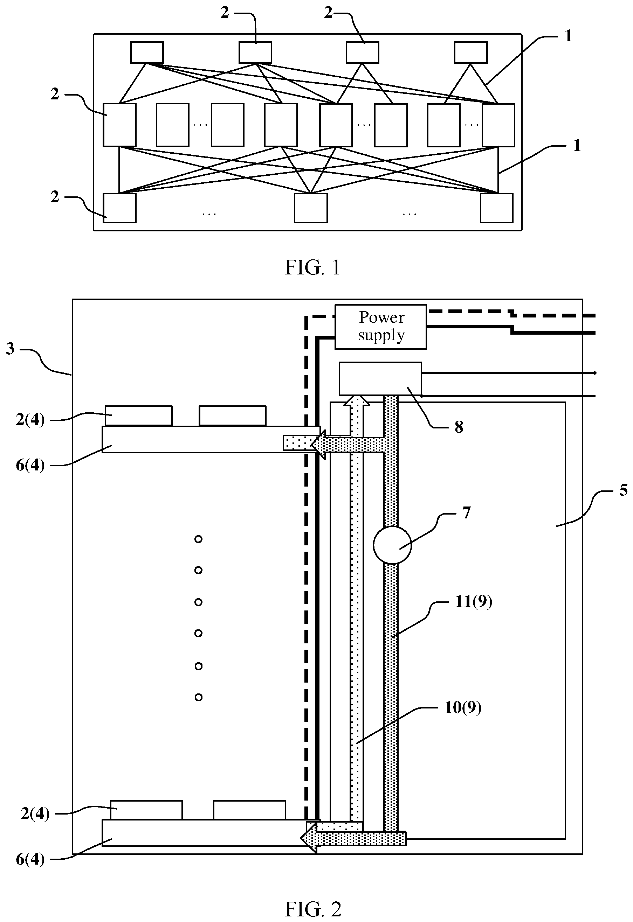

FIG. 1 is a diagram of a connection between circuit board modules in a conventional technology. As shown in FIG. 1, cables 1 are used for implementing signal transmission and power supply between different circuit board modules 2. The cables 1 occupy large space, and a burden of arranging the cables 1 is heavy. With comprehensive application scenarios such as a high speed, high power density, high node power consumption, a large bandwidth, and a low insertion loss, a size of the cable 1 becomes larger. Consequently, more circuit space is occupied, and the burden of arranging the cables 1 is heavier. In addition, the different circuit board modules 2 need the cables 1 for signal transmission and/or power supply. This increases a quantity of cables 1 in the circuit board module 2, occupied space, and maintenance complexity.

In view of this, this application provides a cold plate assembly. A cold plate body is integrated with a flexible printed circuit 13 disposed with a high-speed signal cable and a power interconnection cable, so that the cold plate assembly becomes a structure having three functions: cooling, signal transmission, and power supply. The cable 1 does not need to be used for signal transmission and/or power supply, so that a size of an electronic device is reduced and maintenance work of the electronic device is simplified.

The cold plate assembly may be configured to perform heat dissipation processing on the electronic device. The electronic device may be a device with a high power consumption component, such as a computing device (for example, a server), a network device (for example, a switch), or a storage device (for example, a storage array). Optionally, the electronic device may include a cabinet body and a node disposed in the cabinet body. The node includes the circuit board module 2, the circuit board module 2 includes a circuit board 15, for example, a printed circuit board (printed circuit board, PCB), and an electronic component 16 is disposed on the circuit board 15. For ease of description, in this embodiment of this application, an example in which the electronic device is the server is used for description.

As functions of the server become more diversified, power of the electronic component 16 disposed on the circuit board 15 of the node also increases, and more heat is generated. For example, a plurality of electronic components are usually disposed on the circuit board 15, and the plurality of electronic components include a high-power-consumption component, such as a central processing unit (central processing unit, CPU), an artificial intelligence (artificial intelligence, AI) chip, or a graphics processing unit (graphics processing unit, GPU), and are configured to perform computing-intensive or access memory-intensive service data processing such as artificial intelligence or high-performance computing (high-performance computing, HPC). As a computing capability of the chip increases, a requirement for heat dissipation also increases.

It should be noted that, in addition to the high-power-consumption component such as the CPU or the GPU, the cold plate assembly in this application may further dissipate heat for another component according to a service requirement. For example, the cold plate assembly may also be configured to dissipate heat for a memory.

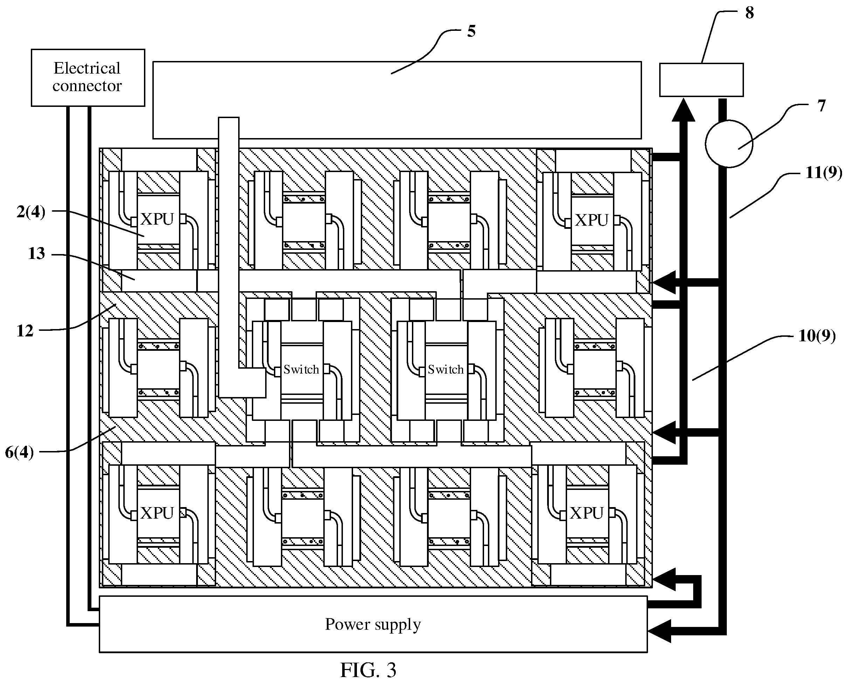

FIG. 2 is a diagram of a lateral structure of an electronic device having a liquid cooling system according to this application. FIG. 3 is a diagram of a top-view structure of an electronic device according to this application. As shown in FIG. 2 and FIG. 3, the electronic device in this application includes a housing 3 and a circuit board assembly 4, a liquid cooling system is further disposed in the electronic device, and the circuit board assembly 4 is disposed in the housing 3. When the electronic device is a cabinet server, the housing 3 may also be referred to as a cabinet body, and the circuit board assembly 4 may also be referred to as a node, for example, a blade server. The node is disposed in the cabinet body. In a specific embodiment, the electronic device may include a plurality of nodes, and may further include a circuit board for management 5. Each node may be electrically connected to the circuit board for management 5, to perform signal transmission, supply power to the node, implement communication between different nodes, or the like.

The circuit board assembly 4 includes a cold plate assembly 6 and a plurality of circuit board modules 2, and the plurality of circuit board modules 2 are mounted on the cold plate assembly 6. In a specific embodiment, the liquid cooling system includes a liquid pump 7, a cooling device 8, a liquid pipeline 9, and the cold plate assembly 6. The liquid pump 7, the cooling device 8, and the cold plate assembly 6 are connected through the liquid pipeline 9. The liquid pump 7 drives cooling liquid to flow between the cooling device 8 and the cold plate assembly 6, so that the cold plate assembly 6 is configured to dissipate heat for the circuit board module 2.

With reference to FIG. 2, when the cold plate assembly 6 is connected to the cooling device 8, the liquid pipeline 9 may include a liquid inlet channel 10 and a liquid outlet channel 11. The liquid inlet channel 10 and the liquid outlet channel 11 are separately connected to the cooling device 8. The liquid pump 7 may be disposed in the liquid inlet channel 10 and/or the liquid outlet channel 11. The foregoing cooling liquid flows out of the cooling device 8 from the liquid outlet channel 11, flows to the cold plate assembly 6, and flows back to the cooling device 8 from the liquid inlet channel 10 after the cold plate assembly 6 performs heat exchange, to implement circulation of the cooling liquid. In a specific embodiment, cooling liquid flow channels 14 of different cold plate assemblies 6 may be connected in series or in parallel. This is not limited in this application. When cold plate assemblies 6 of different nodes are connected in parallel, heat exchange efficiency is high, and a heat dissipation effect for the circuit board module 2 is good. When the different cold plate assemblies 6 are connected in series, a design of the liquid pipeline 9 may be simplified. This helps reduce a size of the electronic device.

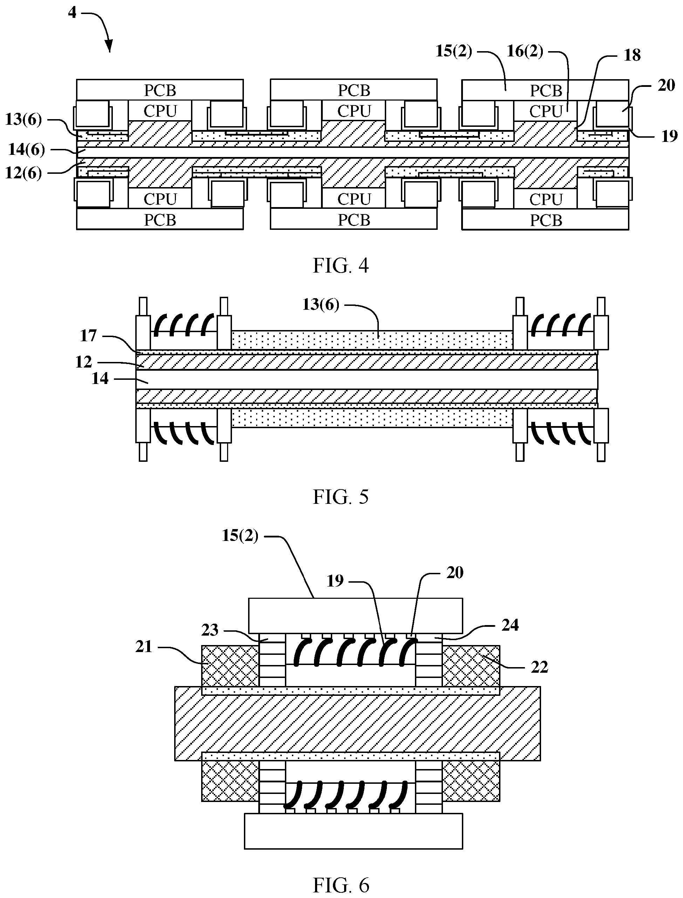

FIG. 4 is a diagram of a lateral structure of a circuit board assembly according to this application. As shown in FIG. 3 and FIG. 4, the circuit board assembly 4 includes the cold plate assembly 6 and the plurality of circuit board modules 2. The circuit board module 2 is detachably connected to the cold plate assembly 6, and the plurality of circuit board modules 2 may be electrically connected by using the cold plate assembly 6. In addition, the cold plate assembly 6 has a cooling liquid flow channel 14 inside, and the cooling liquid flows through the cooling liquid flow channel 14 under driving of the liquid pump 7. In this technical solution, the cold plate assembly 6 has three functions: heat dissipation, signal transmission, and power supply. To be specific, the cold plate assembly 6 can dissipate heat for an electronic component 16 in the circuit board module 2, and can implement signal transmission and a power supply connection for different circuit board modules 2, so that connections of cables 1 are reduced. This helps reduce cables in the electronic device and reduce a size of the electronic device.

Still refer to FIG. 3 and FIG. 4. In a specific embodiment, the circuit board module 2 includes a circuit board 15 and the electronic component 16. The electronic component 16 may be a chip, and the chip is electrically connected to the circuit board 15, so that the electronic component 16 is electrically connected to another electronic component 16 or the circuit board module 2 through the circuit board 15. The electronic component 16 may generate much heat in a working process, and heat dissipation needs to be performed on the electronic component 16. Therefore, the electronic component 16 may be connected to a cold plate body 12 of the cold plate assembly 6 in a thermally conductive manner. For example, the electronic component 16 is connected to the cold plate body 12 in direct contact and in a thermally conductive manner. Alternatively, a heat conduction layer may be disposed between the electronic component 16 and the cold plate body 12, to improve reliability of contact between the electronic component 16 and the cold plate body 12, improve heat exchange efficiency, and improve a heat dissipation capability of the electronic component 16, so that work efficiency of the electronic component 16 is high, and a service life is long.

In a specific embodiment, a specific type of the circuit board module 2 is not limited. For example, the circuit board module 2 may be a switching module, a computing module, a storage module, or the like, and the switching module, the computing module, the storage module are respectively configured to implement signal switching, computing, and storage.

The circuit board assembly 4 in FIG. 3 and FIG. 4 is used as an example, at least two circuit board modules 2 included in the circuit board assembly 4 may include a switching module and a computing module, and the computing module is arranged on a periphery of the switching module. In this solution, a large quantity of computing modules may be disposed adjacent to the switching module. Therefore, the large quantity of computing modules are close to the switching module, so that the large quantity of computing modules are connected to the switching module by using the cold plate assembly 6, to implement the signal switching, and efficiency of signal transmission between the switching module and the computing module can be improved.

FIG. 5 is a diagram of a structure of a cold plate assembly according to this application. As shown in FIG. 5, the cold plate assembly 6 includes a cold plate body 12 and a flexible printed circuit 13. The cold plate body 12 includes a cooling liquid flow channel 14. The cooling liquid flow channel 14 is connected to a cooling device 8 and a liquid pump 7. The liquid pump 7 is configured to drive cooling liquid to flow between the cooling device 8 and the cooling liquid flow channel 14. The cooling liquid is used to conduct heat of an electronic component 16, to implement a function of performing, by the cold plate assembly 6, heat dissipation on the electronic component 16 in a circuit board module 2. Specifically, the cold plate body 12 is connected to the electronic component 16 in the circuit board module 2 in a thermally conductive manner, and in particular, the cold plate body 12 is connected to the electronic component 16 in the circuit board module 2 in a thermally conductive manner, to dissipate heat for the electronic component 16 in the circuit board module 2. Specifically, the electronic component 16 may be directly connected to the cold plate body 12 in contact, or a heat conduction layer is disposed between the electronic component 16 and the cold plate body 12, to implement a thermally conductive connection between the cold plate body 12 and the circuit board module 2.

A flexible printed circuit 13 is fixed on a surface of the cold plate body 12, and an interconnection circuit and at least two interfaces are disposed on the flexible printed circuit 13. The at least two interfaces are electrically connected to the interconnection circuit, so that the interfaces are electrically connected by using the interconnection circuit. The circuit board module 2 is connected to the interfaces, so that at least two circuit board modules 2 may be electrically connected by using the interconnection circuit. The interconnection circuit includes a high-speed signal cable and a power interconnection cable, and the high-speed signal cable and the power interconnection cable are electrically connected to the interfaces respectively, to be electrically connected to the electronic component 16 of the circuit board module 2 separately. The high-speed signal cable is used to communicate a high-speed signal with the electronic component 16, and the power interconnection cable is used to supply power to the electronic component 16. In this way, functions of signal transmission and power supply of the cold plate assembly 6 for the circuit board module 2 can be implemented. The flexible printed circuit 13 is made of a flexible material. This facilitates deformation with a shape of the cold plate body 12, and can improve reliability of a connection between the flexible printed circuit 13 and the cold plate body 12.

In this solution, the flexible printed circuit 13 disposed with the high-speed signal cable and the power interconnection cable is integrated with the cold plate body 12, to implement three functions: heat dissipation, signal transmission, and power supply, and no additional connection structure such as a connector is required. In comparison with a conventional technology in which three functions, namely, heat dissipation, signal transmission, and power supply, need to be implemented by using different structures, the three functions can be implemented by using an integrated cold plate assembly, and a size of the cold plate assembly is small. Therefore, a size of a circuit board assembly 4 having the cold plate assembly is also reduced, space occupied by the circuit board assembly 4 can be reduced, and integration of the electronic device can be improved. Therefore, to satisfy a requirement of a rapidly developing service, a heavy computing node with features such as a high speed, high density, a large bandwidth, and high power consumption is provided.

In addition, in the technical solution provided in this application, the high-speed signal cable and the power interconnection cable that are disposed in the flexible printed circuit 13 are used for replacing a cable 1 in an existing technology. Therefore, the cable 1 does not need to be arranged, so that the circuit board assembly 4 is easy to manage. A specific manner of integrating the flexible printed circuit 13 and the cold plate body 12 is not limited.

In a possible implementation, the cold plate body 12 has a mounting groove, and the flexible printed circuit 13 is embedded in the mounting groove. In this solution, a peripheral side of the mounting groove of the cold plate body 12 protrudes from a groove bottom of the mounting groove, and the cold plate body 12 may be in contact with the electronic component 16 or may be connected to the electronic component 16 in a thermally conductive manner, to help improve heat dissipation efficiency of the cold plate assembly 6 for the circuit board module 2.

In another possible implementation, the cold plate body 12 has a planar mounting area, and the flexible printed circuit 13 is mounted in the planar mounting area of the cold plate body 12.

In another possible implementation, the flexible printed circuit 13 may be attached to the surface of the cold plate body 12, and the flexible printed circuit 13 is fixed to the cold plate body 12 in a bonding manner. Optionally, the flexible printed circuit 13 may be further welded to the surface of the cold plate body 12, and the flexible printed circuit 13 is fixed to the cold plate body 12 in a welding manner.

Further, in addition to the solution described in the foregoing solution, to improve a heat dissipation effect of a cold plate, an insulated thermal interface material (Thermal Interface Material, TIM) layer 17 may be further disposed between the flexible printed circuit 13 and the cold plate body 12.

For a specific solution, still refer to FIG. 5. The cold plate body 12 has good thermal conductivity, and is generally made of a metal material, so that the cold plate body 12 has conductivity. In this embodiment, the insulated thermal interface material layer 17 may enable the flexible printed circuit 13 to be insulated from the insulated thermal interface material layer 17, and therefore, a requirement for insulation of a surface of the flexible printed circuit 13 is low. In addition, the insulated thermal interface material layer 17 has good thermal conductivity. This helps dissipate heat for the flexible printed circuit 13 by using the cold plate body 12.

A specific manner of disposing the cooling liquid flow channel 14 in the cold plate body 12 is not limited. In a possible implementation, the cooling liquid flow channel 14 is a liquid cooling cavity in the cold plate body 12. To improve heat exchange efficiency, a heat sink fin may be further disposed in the liquid cooling cavity. In another possible implementation, the cooling liquid flow channel 14 in the cold plate body 12 may be arranged in serpentine.

In a specific embodiment, a specific manner of connecting the circuit board module 2 to the flexible printed circuit 13 is not limited, and the interface disposed on the flexible printed circuit 13 refers to a structure used by the interconnection circuit in the flexible printed circuit 13 to connect to the circuit board module 2. In a possible implementation, the interface is a welding point, for example, a fillet weld leg, and the circuit board module 2 is electrically connected to the interface in the welding manner. This solution helps reduce the size of the circuit board assembly 4 and improve the integration of the electronic device.

Still refer to FIG. 4 and FIG. 5. In a possible implementation, the flexible printed circuit 13 is integrated on surfaces on two sides of the cold plate body 12, and two sides of the cold plate assembly 6 are respectively connected to the circuit board modules 2. In this solution, a heat dissipation capability of the cold plate body 12 and an interconnection capability of the flexible printed circuit 13 may be fully used. This helps improve integration of the circuit board assembly 4 and reduce the space occupied by the circuit board assembly 4.

A quantity of flexible printed circuits 13 and a shape of the flexible printed circuit 13 in this application are not limited, and may be specifically designed according to a requirement. For example, an area of the flexible printed circuit 13 is less than an area of a surface that is of the cold plate body 12 and that faces the flexible printed circuit 13. Specifically, the flexible printed circuit 13 avoids a region in which the cold plate body 12 is connected to the electronic component 16 in a thermally conductive manner. In this solution, a manner of disposing the flexible printed circuit 13 enables the electronic component 16 to be directly connected to the cold plate body 12 in a thermally conductive manner, and no flexible printed circuit needs to be disposed between the electronic component 16 and the cold plate body 12, so that a link between the electronic component 16 and the cold plate body 12 is shortened, thermal resistance is reduced, and heat exchange efficiency of the electronic component 16 is improved.

In a possible implementation, the flexible printed circuit 13 may be in an irregular shape, and may be designed according to a requirement. During specific disposing, the flexible printed circuit 13 avoids the region in which the cold plate body 12 is connected to the electronic component 16 in a thermally conductive manner, and a distance between different circuit board modules 2 connected to the flexible printed circuit 13 is short, to reduce a loss in a signal transmission process and improve signal transmission efficiency. In another possible implementation, the flexible printed circuit 13 may be a flexible printed circuit in a regular edge shape, for example, in a square or rectangular shape; or an edge shape of the flexible printed circuit 13 is the same as an edge shape of the cold plate body 12. In this solution, the flexible printed circuit 13 may be provided with a hollow-out structure, and the hollow-out structure avoids the region in which the cold plate body 12 is connected to the electronic component 16 in a thermally conductive manner.

In addition, in different implementations, the cold plate assembly 6 may include one or more flexible printed circuits 13. When the cold plate assembly 6 includes one flexible printed circuit 13, the flexible printed circuit 13 may be in the irregular shape or the regular edge shape. Details are not described herein. When the cold plate assembly 6 includes a plurality of flexible printed circuits 13, the plurality of flexible printed circuits 13 are disposed away from the region in which the cold plate body 12 is connected to the electronic component 16 in a thermally conductive manner.

Further, to further enhance a heat conduction effect of the cold plate body and the electronic component, still refer to FIG. 4. In a specific embodiment, the cold plate body 12 may have a boss 18, and the boss 18 is connected to the electronic component 16 in a thermally conductive manner. Specifically, when the boss 18 is connected to the electronic component 16, the electronic component 16 is connected to the boss 18 in direct contact, or a heat conduction layer may be disposed between the electronic component 16 and the cold plate body 12, to implement a thermally conductive connection between the electronic component 16 and the boss 18. When the boss 18 is specifically disposed, a location of the boss 18 may be disposed based on a layout location of the circuit board module 2, so that the boss 18 and the electronic component 16 of the circuit board module 2 can be connected to each other in a thermally conductive manner. Specifically, an area of a surface that is of the boss 18 and that faces the electronic component 16 may be greater than an area of a surface that is of the electronic component 16 connected to the boss 18 in a thermally conductive manner and that faces the boss 18, so that an entire surface of the electronic component 16 can be in contact with the boss 18, to improve a heat dissipation effect of the electronic component 16. In this solution, the boss 18 is disposed on the cold plate body 12, and the boss 18 extends toward the circuit board 15, so that a height difference between the electronic component 16 and another structure in the circuit board assembly 4 can be supplemented. In this way, the electronic component 16 can be fully in contact with the cold plate body 12, to improve the heat dissipation capability of the electronic component 16. In a possible implementation, the boss 18 extends out of the hollow-out structure of the flexible printed circuit 13.

FIG. 6 is a diagram of a partial sectional view of another circuit board assembly 4 according to this application. As shown in FIG. 4 and FIG. 6, the foregoing interface is a first connector 19, and the first connector 19 is electrically connected to the high-speed signal cable and the power interconnection cable. Correspondingly, the circuit board module 2 further includes a second connector 20. The second connector 20 is disposed on the circuit board 15, and is electrically connected to a circuit pattern in the circuit board 15. The second connector 20 is electrically connected to the electronic component 16 through the circuit board 15. The first connector 19 and the second connector 20 are adaptively connected. In this solution, the electronic component 16 in the circuit board module 2 is electrically connected to the interconnection circuit of the flexible printed circuit 13 in the cold plate assembly 6 by using the first connector 19 and the second connector 20. Optionally, the first connector 19 and the second connector 20 are detachably connected in a connection manner such as plug-in, so that the circuit board module 2 is detachably connected to the cold plate assembly 6, and the circuit board module 2 may be replaced according to a requirement. For example, when the circuit board module 2 is damaged, or a configuration of the circuit board assembly 4 changes, different first connectors 19 and second connectors 20 may be disassembled and connected according to a requirement, and the circuit board assembly 4 may be flexibly replaced, so that flexibility is high. In addition, the first connector 19 and the second connector 20 that are adapted in this solution may further implement positioning, and a process of assembling and disassembling the circuit board module 2 is simple.

In a possible implementation, convenient mounting of the circuit board module to the cold plate assembly may be implemented by using an elastic connector. Still refer to FIG. 4 and FIG. 6, in a specific embodiment, the first connector 19 and the second connector 20 are elastic connectors. In this solution, the circuit board module 2 is connected to the cold plate assembly 6 by using the elastic connector. The elastic connector has elasticity to some extent. In a specific embodiment, a pin of the elastic connector may be an elastic pin, or the elastic connector is connected to an elastic member, and may be deformed along an insertion direction of the first connector 19 and the second connector 20. A floating connection may be implemented between the circuit board module 2 and the cold plate assembly 6, to absorb a tolerance between the circuit board module 2 and the cold plate assembly 6, reduce a coplanar constraint between the circuit board module 2 and the cold plate assembly 6, and facilitate mounting.

In a possible implementation, to position assembly of the circuit board module 2 to the cold plate assembly 6, a first positioning assembly may be further disposed on the cold plate assembly 6, and the first positioning assembly is fixedly connected to the cold plate body 12. Specifically, the first positioning assembly may be welded to the cold plate body 12, connected to the cold plate body 12 by using a thread, bonded to the cold plate body 12, or the like, and a specific fixing manner is not limited. For example, refer to FIG. 6. The first positioning assembly includes a first guide pin 21 and a second guide pin 22, a preset distance exists between surfaces that are of the first guide pin 21 and the second guide pin 22 and that face each other, and the first guide pin 21 and the second guide pin 22 form a position-limiting slot. The circuit board module 2 includes a second positioning assembly, and the second positioning assembly may be specifically fixed to the circuit board 15. Specifically, the second positioning assembly may be welded to the circuit board 15, connected to the circuit board 15 by using a thread, bonded to the circuit board 15, or the like, and a specific fixing manner is not limited. The second positioning assembly includes a first holder 23 and a second holder 24, and a preset distance exists between surfaces that are of the first holder 23 and the second holder 24 and that face away from each other. The first holder 23 and the second holder 24 are mounted between the first guide pin 21 and the second guide pin 22. Specifically, the second positioning assembly is inserted into the first positioning assembly, and is configured to position the circuit board module 2 and the cold plate assembly 6. In this way, the first connector 19 and the second connector 20 are easily aligned, to facilitate the plug-in of the first connector 19 and the second connector 20.

Specifically, a theoretical value of the preset distance between the surfaces that are of the first guide pin 21 and the second guide pin 22 and that face each other may be equal to a theoretical value of the preset distance between the surfaces that are of the first holder 23 and the second holder 24 and that face away from each other, but there can be a tolerance, provided that the first positioning assembly and the second positioning assembly can implement positioning.

In specific implementation, the first guide pin 21 and the second guide pin 22 may be disposed at two ends of the first connector 19, and the first holder 23 and the second holder 24 may be disposed at two ends of the second connector 20, to facilitate the plug-in of the first connector 19 and the second connector 20.

Still refer to FIG. 5. When signal transmission and power supply cannot be implemented by using the interconnection circuit disposed on the flexible printed circuit, a board to board connector may be alternatively used for connection. Optionally, the cold plate assembly 6 may further include a first board to board connector 25. The first board to board connector 25 is also electrically connected to the interconnection circuit of the flexible printed circuit 13. Specifically, the first board to board connector 25 is electrically connected to the high-speed signal cable and the power interconnection cable separately. The first board to board connector 25 is configured to electrically connect to the cable 1.

Specifically, for the board to board connector (Board to Board Connector, BTB) in this embodiment of this application, the board to board connector is mounted on the circuit board, and may be connected to a peer connector. Specifically, the peer connector may be connected to a cable. In a possible implementation, one group of connection assemblies includes two circuit boards and one cable. In the two circuit boards, one circuit board is fixedly connected to one board to board connector, and the other circuit board is fixedly connected to the other board to board connector. Two ends of the cable respectively have peer connectors, and each peer connector is connected to one board to board connector, so that the two circuit boards are connected through the cable. In this way, a connection of electronic components disposed on the two circuit boards is implemented.

The first board to board connector shown in FIG. 5 may be used not only inside and outside a same circuit board assembly, but also in a connection of a plurality of circuit board assemblies.

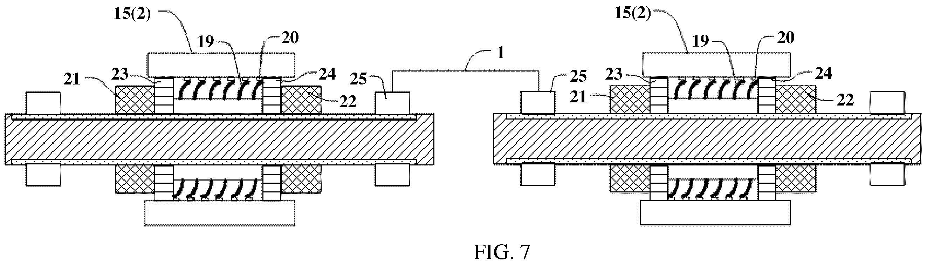

FIG. 7 is a diagram of a structure of an electronic device according to an embodiment of this application. As shown in FIG. 7, when the electronic device includes a plurality of circuit board assemblies 4, each of different circuit board assemblies 4 is provided with a first board to board connector 25, and a cable 1 may be connected to first board to board connectors 25 of the different circuit board assemblies 4, so that high-speed signal transmission and power signal transmission can be implemented between the different circuit board assemblies 4 through the cable 1.

In a specific implementation, the first board to board connector 25 may alternatively be an elastic connector, so that a floating connection between the cable 1 and the first board to board connector 25 can be implemented.

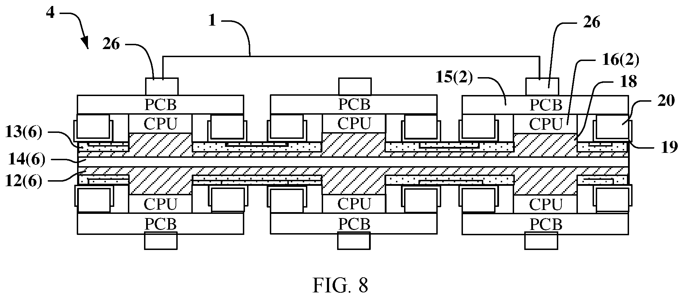

In addition to the foregoing circuit board assemblies being connected by using the board to board connector, a circuit board module in the circuit board assembly may also be connected to a circuit board module that is far away by using the board to board connector. For example, in a possible implementation, FIG. 8 is a diagram of a lateral structure of a circuit board assembly according to this application. Refer to FIG. 8. In another embodiment, a circuit board module 2 is further provided with a second board to board connector 26, and the second board to board connector 26 is configured to electrically connect to a cable 1. An electronic device includes a plurality of circuit board assemblies 4, so that circuit board modules 2 disposed on different circuit board assemblies 4 may be electrically connected by using the second board to board connector 26 and in cooperation with the cable 1. Alternatively, in a same circuit board assembly 4, a plurality of circuit board modules 2 are disposed, and it is difficult to implement interconnection between some circuit board modules 2 by using a flexible printed circuit 13. For example, for interconnection between circuit board modules 2 that are far away from each other, an electrical connection may be implemented by using the second board to board connector 26 and in cooperation with the cable 1.

The second board to board connector 26 may be specifically an elastic connector. Therefore, a floating connection between the cable 1 and the second board to board connector can be implemented.

It is clear that a person skilled in the art can make various modifications and variations to this application without departing from the protection scope of this application. This application is intended to cover these modifications and variations of this application provided that they fall within the scope of protection defined by the following claims of this application and their equivalent technologies.

## Claims

1. A cold plate assembly, wherein the cold plate assembly comprises:
a cold plate body, provided with a cooling liquid flow channel, wherein the cooling liquid flow channel is used for flowing of cooling liquid, and the cooling liquid is used to conduct heat of an electronic component; and
a flexible printed circuit integrated on the cold plate body, provided with a high-speed signal cable and a power interconnection cable, wherein the high-speed signal cable and the power interconnection cable are separately used to electrically connect to the electronic component, the high-speed signal cable is used to communicate a high-speed signal with the electronic component, the power interconnection cable is used to supply power to the electronic component, and the flexible printed circuit is made of a flexible material.

2. The cold plate assembly according to claim 1, wherein the flexible printed circuit is integrated on a surface on one side of the cold plate body, or integrated on surfaces on two sides of the cold plate body.

3. The cold plate assembly according to claim 1 or 2, wherein a surface of the cold plate body has a mounting groove, and the flexible printed circuit is embedded in the mounting groove.

4. The cold plate assembly according to any one of claims 1 to 3, wherein the flexible printed circuit is attached to the surface of the cold plate body.

5. The cold plate assembly according to any one of claims 1 to 4, wherein an insulated thermal interface material layer is disposed between the flexible printed circuit and the cold plate body.

6. The cold plate assembly according to any one of claims 1 to 5, wherein the flexible printed circuit is further provided with a first connector, the first connector is electrically connected to the high-speed signal cable and the power interconnection cable, and the electronic component is connected to the first connector.

7. The cold plate assembly according to claim 6, wherein the first connector is an elastic connector.

8. The cold plate assembly according to any one of claims 1 to 7, further comprising a first positioning assembly, wherein the first positioning assembly comprises a first guide pin and a second guide pin, a preset distance exists between surfaces that are of the first guide pin and the second guide pin and that face each other, and the first positioning assembly is configured to position a location of the electronic component in the cold plate assembly.

9. The cold plate assembly according to any one of claims 1 to 8, wherein the flexible printed circuit is further provided with a first board to board connector, the first board to board connector is electrically connected to the high-speed signal cable and the power interconnection cable, and the first board to board connector is configured to electrically connect to a cable.

10. The cold plate assembly according to any one of claims 1 to 9, wherein an area of the flexible printed circuit is less than an area of a surface that is of the cold plate body and that faces the flexible printed circuit, and the flexible printed circuit avoids a region in which the cold plate body is connected to the electronic component in a thermally conductive manner.

11. An electronic device, comprising the cold plate assembly according to any one of claims 1 to 10 and a plurality of circuit board modules, wherein the circuit board module is mounted on the cold plate assembly, the circuit board module is electrically connected to the high-speed signal cable and is electrically connected to the power interconnection cable, and at least two circuit board modules are electrically connected through the high-speed signal cable and the power interconnection cable.

12. The electronic device according to claim 11, wherein the flexible printed circuit is integrated on surfaces on two sides of the cold plate body, and the circuit board modules are separately disposed on two sides of the cold plate assembly.

13. The electronic device according to claim 11 or 12, wherein the circuit board module comprises a circuit board, an electronic component, and a second connector, the electronic component and the second connector are disposed on the circuit board, and the electronic component and the second connector are electrically connected through the circuit board; and the flexible printed circuit is further provided with a first connector, the first connector is electrically connected to the high-speed signal cable and the power interconnection cable, and the first connector is connected to the second connector.

14. The electronic device according to claim 13, wherein the first connector and the second connector are elastic connectors.

15. The electronic device according to any one of claims 11 to 14, wherein the cold plate assembly further comprises a first positioning assembly, the first positioning assembly comprises a first guide pin and a second guide pin, and a preset distance exists between surfaces that are of the first guide pin and the second guide pin and that face each other; and the circuit board module further comprises a second positioning assembly, the second positioning assembly comprises a first holder and a second holder, the preset distance exists between surfaces that are of the first holder and the second holder and that face away from each other, and the first holder and the second holder are mounted between the first guide pin and the second guide pin, and are used to position the circuit board module and the cold plate assembly.

16. The electronic device according to any one of claims 11 to 15, wherein the cold plate body has a boss, and the boss is connected to the electronic component in a thermally conductive manner.

17. The electronic device according to any one of claims 11 to 16, wherein the circuit board module is further provided with a second board to board connector.

18. The electronic device according to any one of claims 11 to 17, wherein at least two circuit board modules comprise a switching module and a computing module, and the computing module is arranged on a periphery of the switching module.

19. A liquid cooling system, comprising a cooling device, a liquid pump, and the cold plate assembly according to any one of claims 1 to 10, wherein the cold plate assembly is disposed in the electronic device according to any one of claims 11 to 18, and the cooling device and the liquid pump are connected to a cooling liquid flow channel of the cold plate body.
